# EUROPEAN PATENT SPECIFICATION

(11) **EP 2 359 401 B1**
(45) Date of publication and mention of the grant of the patent: **27.05.2015**
(21) Application number: 09752197.5
(22) Date of filing: 20.11.2009
(51) Int. Cl.: H01L 27/142

(54) **SOLAR MODULE HAVING INTEGRATED ELECTRONIC DEVICES and related Method to manufacture it**
Solarmodul mit integrierten elektronischen Vorrichtungen und Herstellungsverfahren dazu
Module solaire avec dispositifs électroniques integrés et son procédé de fabrication

(30) Priority: 20.11.2008 EP 08020224; 06.03.2009 EP 09003276
(43) Date of publication of application: 24.08.2011
(73) Proprietor: Saphire Solar Technologies ApS, 2960 Rungsted Kyst (DK)
(72) Inventor: SAFIR, Yakov, DK-1820 Frederiksberg C (DK)
(74) Representative: Budde Schou A/S
(86) International application number: PCT/EP2009/065556
(87) International publication number: WO 2010/057978

(56) References cited:
- EP-A1- 1 326 286
- EP-A1- 1 753 033
- WO-A1-2008/043814
- CA-A1- 2 631 238
- FR-A1- 2 853 469
- GB-A- 1 010 476
- JP-A- 2002 367 046
- US-A- 4 330 680
- US-A- 4 481 378
- US-A- 5 164 019
- US-A- 5 973 257

## Description

The present invention relates to a solar module having integrated electronic devices and a method of manufacturing a solar module having integrated electronic devices..

In this context, high voltage should be understood to mean any voltage higher than the usual voltage achieved by a conventional semiconductor based wafer, i e 0.3V-0.6V.

Solar cells are well known in the art of energy production for producing electric energy in an efficient and environmentally friendly way. A solar cell relies on the photovoltaic effect for generating electric energy from visual radiation, which primarily but not necessarily constitutes solar radiation A typical solar cell consists of a thin semiconductor wafer (solar wafer) having a single large p-n junction applied on the front surface facing the light. Each of the two surfaces (front and back) of the solar cell is provided with a metal contact constituting a plus and a minus pole for providing a direct current (DC) through the semiconductor based wafer. The photons impinging on the p-n junction will excite charge carriers, which will initiate a current towards its respective pole.

The DC output current may be used directly for powering a facility or charging a battery, or alternatively a converter may be employed to convert the DC current to an AC current, which may be delivered to a transmission grid The above type of solar cell yields a voltage of between 0.3V-0.6V and typically 0.5V whereas the voltage is weakly dependent on the amount of radiation received by the solar cell. The current is proportional to the amount of radiation received and to the solar cell area. The above applications typically need to be provided with a higher voltage than the voltage delivered by a single cell. Due to the very low voltage provided by each individual solar cell, each solar module has to contain a large amount of solar cells. For example, in a typical commercial solar module for a nominal voltage of 60V, typically 144 cells are connected in series. Therefore, to be able to achieve higher voltages a plurality of solar cells have to be connected in series to form a high voltage solar module. Typically a plurality of modules are further connected into a solar array and installed in places of high solar intensity, such as on roofs etc.

The above example assumes that each cell yields around 0.5V minus any resistive losses within the module Solar cells for high voltage solar modules are typically made by splitting a large semiconductor based wafer into several smaller semiconductor based wafers. Since semiconductor based wafers are very brittle and fragile, the wafer may easily shiver and be damaged beyond repair. Additionally, connecting several solar cells in series requires soldering, which is one of the major sources of malfunction in the module. By having a single non-conductive soldering point the complete module may be rendered useless. If a higher voltage is needed, even more cells need to be connected in series and a failure is even more likely. Solar cells can also be connected in parallel or be made of a semiconductor based wafer having a large area. In both cases serious problems occur, since the resulting high DC current will either result in large resistance losses and thereby high risk of short circuit or require very thick cables with thick isolation caps

It is further known from US 5,665,175 to make a bifacial semiconductor wafer for a solar cell having a thin plate of either mono-crystalline or poly-crystalline silicon, being either p-type, n-type or intrinsic.. The plates are made out of large blocks or rods of silicon by laser sawing. An n-type material, such as phosphor (P) or gallium (Ga) is diffused on one surface of the wafer for form a p-n- junction.. It is further known from US 5,665,175 to diffuse a p-type material to the opposite surface of the semiconductor wafer to achieve a bifacial solar cell Such n-type material may e.g. be boron (B) or arsenic (As).

From US 6,423,568 it is known to fabricate a silicon solar cell having p-doped regions and n-doped regions on the same side. The p-doped regions are electrically connected to form one pole of the solar cell and the n-doped regions are electrically connected to form the opposite pole of the solar cell. From this a plurality of parallel connected cells is achieved. Document WO2008/043814A discloses a series of solar cells.
GB 1 010 476 discloses a photo-electric generator comprising a plurality of regions of semiconductor material. One part of each region is of one conductivity type and another part of each region is of opposite conductivity type. The two part together forming a p-n junction sensitive to radiation The p-n junctions are connected in series by electrical connections. Semiconductor material of one conductivity type is joined to the parts of the regions of opposite conductivity type

From US 4,330,680 it is known to arrange a row of strip shaped semiconductor junctions on each of the two surfaces of a semiconductor substrate possessing a high ohmic resistance. The junctions having p+ and n+ conduction characteristics in alternation and being parallel to to each other and spaced at intervals in such a way that a semiconductor junction having a p+ conduction characteristic on one surface of the semiconductor substrate is, in each case located opposite a semiconductor junction having an n+ conduction characteristic on the other surface Printed circuit tracks are arranged in alternation on one surface and on the other surface of the semiconductor substrate connecting in each case one series of solar cell junctions with a neighbouring series, in series connection.

From US 4,481,378 a photovoltaic module is disclosed which is protected from reverse bias damage and which displays minimal power loss resulting from temporary inoperativeness of one or more individual photovoltaic cells included in the module. The module includes a plurality of series connected photovoltaic cells Protection from inoperativeness of one or more of these cells is provided by a reversely poled diode across each of the series connected cells.

However, none of the above technologies provide a semiconductor wafer yielding a voltage substantially higher than the voltage of a single p-n junction It is therefore an object of the present invention to provide technologies for producing a solar cell consisting of a single wafer, which is capable of delivering a high voltage

In the present context it would be beneficial to be able to include a large number of p-n junctions on the same semiconductor based wafer and connect them electrically directly on the wafer to avoid the need of splitting large cells and solder the individual cells together to achieve higher voltage. It would also be beneficial to be able to increase the area of the semiconductor based wafer without increasing the current proportionally. Both for solar cell and solar module production it would be more cost effective to produce cells having a large area

The accurate application of fluids on a substrate has been described in WO 2006/111247. To achieve a phosphor doping, the semiconductor based wafer is firstly damped with phosphor acid Subsequently, the phosphor acid is allowed to diffuse into the semiconductor based wafer by the use of a high temperature oven

Since the solar wafer is typically very brittle and may rupture when subjected to weak to moderate shocks, the solar wafer must be encapsulated within an enclosure for protection. Since solar wafers are mostly located outdoors and on exposed locations such as on roofs etc., the enclosure must be made substantially rigid. The enclosure is typically made by providing a transparent front plate and a non-transparent back plate of either glass or a polymeric material The solar wafer is encapsulated between the front layer and the back layer to form a laminate structure. The polymeric layers give the solar cell additional rigidity. The thickness of the enclosure should be as thin as possible so as not to subject the support structure, such as the roof, to high forces and to save material

Since a large number of solar cells are typically connected in series within the solar module, the solar module is very sensitive to reverse biasing of a single solar cell. A reverse biasing of a single solar cell may cause the solar cell to consume power instead of producing power A reverse biasing may be caused by internal failure such as a permanent defect in the solar cell, or alternatively an external effect such as shading of the solar cell. The shading may be temporary, caused by e.g. a bird or a piece of debris. In such cases the solar cell will resume power production when the shading is removed. Bypass diodes are known in the art for providing remedy to the above problem. By providing a diode in anti-parallel configuration in relation to one or more solar cells, the solar cell(s) may be bypassed or bridged when reversed biased Under normal power generating conditions, the solar cell is in a positive biased state conducting and producing current, and the bypass diode is in a negatively biased state, i.e. non-conducting. When the solar cell is negatively biased, the bypass diode, being in anti-parallel configuration, will be positively biased and thereby conducting. Typically, the bypass diodes are located in a junction box outside the solar module, e.g. fixed to the back of the solar module In order to make a compact and cost- effective solar module it would be desirable to avoid the junction box and to integrate the bypass diodes into the enclosure of the solar module. Special low profile diodes are available for avoiding bulges in the enclosure and being able to retain the shallow profile of the enclosure as described above.. Another reason for avoiding junction boxes is the increased need for non-standard modules, i.e. curved modules, glass/glass modules or BIPV (building integrated photovoltaic), where standard junction boxes cannot be accommodated due to architectural requirements.

It is well known in the art that bypass diodes may be integrated into the solar module. One example of a solar module having integrated bypass diodes may be found in international patent application no. PCT/US2005/011949 (publication no. WO 2005/101511). In WO 2005/101511, a conductive board including bypass diodes is positioned near the edge inside the solar module for bypassing a set of solar cells located inside the module. Another example may be found in US 5,616,185, which describes a solar cell assembly, having a bypass diode integrated into the semiconductor wafer The drawback of integrating the bypass diodes into the semiconductor wafer is that hotspots may occur due to overheating of a single diode Such hotspots may cause the solar module to fail Overheating of the bypass diodes may in some cases result in the solar module catching fire, which would pose a significant security risk, especially when the solar module is located in populated areas, such as on rooftops etc Cooling means are, therefore, typically necessary for avoiding overheating and hotspots. Such cooling means add to the overall thickness of the solar module. Additionally, if using a bifacial solar cell according to US 5,665,175, the backside of the solar wafer is occupied by an active area and, thus, not accessible for accommodating electronic devices It is, therefore, an object according to the present invention to provide technologies for avoiding hotspots by providing distributed bypass diodes.

It may further be desired to include other electronic components in the solar module Such components may range from single discrete components such as diodes and resistors to intelligent IC components such as control circuitry, battery units and the like It may be particularly advantageous to include all such components within the solar module to avoid using junction boxes altogether. Solar modules may, thus, be configured to store electrical energy during the daytime and provide energy at nighttime It is, therefore, a further object according to the present invention to provide technologies for providing visual light effects at nighttime

The constantly increasing demand for solar modules has resulted in a shortage of solar grade silicon, i.e. high quality silicon having suitable purity for solar applications. It has, therefore, been contemplated to use metallurgical grade silicon, having a lower purity than solar grade silicon in solar modules Metallurgical grade silicon is widely available at a significantly lower price than solar grade silicon. However, due to the increased amount of impurities in the silicon, the risk of failure in the solar cell is increased. In practice, when using metallurgical grade silicon, there will be a certain percentage of cell failure. When using metallurgical grade silicon, there is, therefore, an increased need for protecting the functional solar cells by providing bypass diodes. There is, thus, a need for accommodating further bypass diodes within the enclosure and, consequently, it is a further object of the present invention to provide a solar module having an increased amount of bypass diodes for being able to use metallurgical grade silicon instead of solar grade silicon

Another effect of the decreased availability of solar grade silicon and the increasing demand for solar modules has been a dramatic increase in solar module theft. Due to the relative compactness and high price of solar modules, it has become very attractive for thieves to steal the installed solar modules Solar module theft typically occurs when the site of the solar modules, typically a building, is left without observation or guarding, such as at nighttime. The previously mentioned document, publication no WO2005/101511, discloses a solar module having an electronic anti-theft device, which causes the solar module to deactivate and interrupt power generation when removed from its installation site However, such designs do not actively prevent the thief from removing the solar module, i.e. the thief may still steal and transport the solar module to a "safe" location and thereafter attempt to remove the electronic anti-theft device. It is, therefore, a further object according to the present invention to provide technologies deterring any unauthorised removal of the solar modules. The invention refers to a solar module and corresponding manufacturing method as recited in claims 1 and 5 respectively. Further advantageous embodiments are recited in dependent claims 2-4. The above needs and objects together with numerous other needs and objects, which will be evident from the below detailed descriptions are obtained by a high voltage semiconductor based wafer defining a front surface for exposure to solar light and an opposite back surface, said semiconductor based wafer including a plurality of p-n junctions each exposed to solar light at said front surface, said plurality of p-n junctions being electrically connected in series for providing a voltage substantially higher than the voltage of a single p-n junction.

The above needs and objects together with numerous other needs and objects, which will be evident from the below detailed descriptions below, are, according to a first aspect, obtained by a high voltage semiconductor based wafer defining a front surface for exposure to solar light and an opposite back surface, said semiconductor based wafer including a plurality of p-n junctions each exposed to solar light at said front surface, said plurality of p-n junctions being electrically connected in series for providing a voltage substantially higher than the voltage of a single p-n junction, said semiconductor based wafer comprises bypass diodes.

By providing a plurality of p-n junction on the wafer, the wafer will in principle comprise a plurality of individual solar cells. The first p-n junction defines a first solar cell and the second p-n junction defines a second solar cell and so on. Surprisingly, in the present context it has been found that the individual solar cells may be applied and electrically connect with a high accuracy to form a series connection. The series connection is understood to mean that the p region of the first p-n junction is connected to the n region of the second p-n junction etc, or the other way around, i.e. the n region of the first p-n junction is connected to the p region of the second p-n junction etc The electrical connection may be printed or deposited on the wafer using state of the art printing or deposition technologies.

In the above-mentioned WO 2006/111247 the inkjet printing technology has been described in connection with phosphor doping inkjet technologies have the advantage of applying a very homogeneous layer onto the wafer Similar technologies may be used for boron doping and for applying the conductors

The high voltage semiconductor based wafer comprises bypass diodes Bypass diodes are well known and used to allow the current to bypass a series of solar cells in case of a malfunction of a single solar cell In some cases malfunctions cause a solar cell to draw power from the solar module or completely prevent current from flowing through the solar module. By including a bypass diode connected parallel to one or more p-n junctions, the effect of a malfunction may be limited to the loss of the p-n junctions coupled to the bypass diode The current then flows through the bypass diode instead of through the p-n junction. The bypass diodes may preferably be used together with the above mentioned metallurgical grade silicon for reducing the risk of a total failure of the solar module due to silicon impurities. In the above context, p-n junction should be understood to mean the solar radiation receiving p-n junctions and not the p-n junction encapsulated within the diode

In a further example the total voltage of said semiconductor based wafer is substantially equal to the voltage of a single p-n junction multiplied with the number of p-n junctions on said semiconductor based wafer By connecting the cells in series and/or parallel, the total voltage of the semiconductor based wafer may be chosen

In a further example said semiconductor based wafer comprises 2-1000 p-n junctions, preferably 10-500 p-n junctions, more preferably 50-200 p-n junctions, and most preferably 144 p-n junctions, or alternatively 50-144 p-n junctions or 144-200 p-n junctions.

Preferably 144 solar cells are connected in series to obtain a total voltage of around 60V. This way, a single wafer may replace a complete solar module, at least with respect to the voltage output. A higher voltage, and consequently lower current, compared to connecting the p-n- junctions in series, has the advantage of allowing thinner conductors on the semiconductor based wafer. Since the conductors will at least partially prevent solar radiation from reaching the p-n junction, thinner conductors on the front surface of the semiconductor based wafer will allow a more efficient semiconductor based wafer. The high voltage output is achieved without the need for any soldering, since the conductors may be printed or deposited on the semiconductor based wafer.

In a further example said p-n junctions are encapsulated within said semiconductor based wafer and/or said p-n junctions are located on said front surface and/or said p-n junctions are located on said back surface

The p-n junctions may be places on different locations on the semiconductor based wafer, i.e. several different geometries are possible. The typical placement of the p-n junctions would be at the front surface close to the incoming solar radiation. However, the back surface may as well comprise p-n junctions or p-n junctions may be encapsulated within the semiconductor based wafer Alternatively several layers of p-n junctions may be used, or a combination of the above

In a further example said semiconductor based wafer comprises metallurgical grade silicon or metallurgical grade semiconductor material.

Typically polycrystalline silicon or monocrystalline silicon of semiconductor grade is used for the semiconductor based wafer.. Low quality silicon increases the risk of impurities, which may increase the risk of failure of the solar cell. Due to the high demand on pure silicon, successful attempts have been made using high quality metallurgical grade silicon for solar cells. Metallurgical grade silicon has more impurities than semiconductor grade silicon, however, the price is significantly lower.

In a further example said semiconductor based wafer comprises:
a first p-n junction defining a first doped area of a first type and a second doped area of a second type, said first p-n junction defining a first current path,
a second p-n junction electrically isolated in relation to said first p-n junction and defining a third doped area of said second type and a fourth doped area of said first type, said second p-n junction defining a second current path, and
a metal layer for electrically connecting said first doped area and said third doped area or alternatively said second doped area and said fourth doped area so that said first and second current paths form a series connection..

The semiconductor based wafer is typically a doped silicon (Si) wafer constituting either a p-type silicon wafer or an n-type silicon wafer The doped areas constitute areas where doping material has been introduced into the silicon typically by a diffusion process. The doping materials may be either n-type material such as phosphor (P), or p-type material such as boron (B). The specific conductivity types of the doped areas are achieved by introducing either n-type material or p-type material on the active areas.

By connecting the solar cells in series so that the first doped area of the first solar cell having a specific type is electrically connected to the third doped area of the second cell having an opposite type, the total voltage provided by the solar cell is doubled.

In the state of the art technologies each semiconductor substrate wafer was only capable of providing a voltage substantially equal to the voltage of a single solar cell There is a high risk of cross diffusion when using two different doping materials which typically prevents including more than one p-n junction on each side of the cell. By cross diffusion is meant the electrical contamination in an active area of the first conductivity caused by atoms of the second conductivity. By having atoms of the second dopant near the first dopant, there is high risk that atoms of the second dopant may enter into the area of the first dopant during the diffusion process. Cross diffusion may occur by having direct contact between two areas of different conductivity Cross diffusion may be avoided e.g. by ensuring a sufficient distance between the areas having different doping.

For instance, nearby boron atoms may diffuse into an area which should solely be accommodated by phosphor atoms, or vice versa. Such contamination leads to reduced efficiency or possibly a total failure of the p-n junction. In the industry, cross diffusion is avoided by having a strict separation of the n-type material and the p-type material. Further separation may be achieved by using masking layers of ultra clean oxide.

Atoms of different conductivity may also be transported by the airflow/gas flow during the high temperature step of the diffusion process Since the doping materials normally are provided in very low concentrations, such as part per billion, even very few atoms of an opposite conductivity may cause a failure.

Surprisingly, in the present context it has been found that by following the process steps further described below, the risk of cross diffusion may be significantly reduced.. Thus, a plurality of p-n junctions may be placed on the same cell without any risk of cross diffusion

In a further example said first type comprises eithera boron, an arsenic or an atom group III material dopant, and said second type comprises either a phosphor, a gallium or an atom group IV material dopant. Typically, boron and phosphor is used as doping material for the first doping type and the second doping type, respectively

In a further example said first doped area of said first type is oriented towards said front surface, said a second doped area of said second type is oriented towards said back surface, said third doped area of said second type is oriented towards said front surface and said fourth doped area of said first type is oriented towards said back surface

The first and second solar cells having an opposite orientation, i.e. the first solar cell may constitute a p-n junction and the second solar cell may constitute a n-p junction, or vice versa This geometry will make the subsequent electrical connection particularly simple, since it does not require a very accurate application of the conductor connecting the p-n junctions and since any laser treatment or plasma etching or chemical etching into the semiconductor based wafer is completely avoided.

In a further example, third and fourth doped areas are connected to further silicon wafers, or other electrical components, by the use of substantially two soldering points for each silicon wafer.

Since the silicon wafers must not be split, substantially only two soldering points are needed to achieve a high voltage solar module. The semiconductor based wafer may be directly connected to other electrical components which are using the energy produced in the semiconductor based wafer. Such electrical components may be a battery chargers etc. For each additional semiconductor based wafer connected in series in relation to the first semiconductor based wafer, one soldering point is needed. Previous solar modules needed one soldering point for each p-n junction or alternatively for each 0.5V voltage increase. Less soldering points have the benefit of greater reliability, since soldering points are prone to causing electrical failures

In a further example, said active areas comprise a silica layer

The doping materials are usually applied by a silica layer. The process currently used is described below.

The presently preferred process has the advantage of only requiring 2 high temperature steps, in contrast to most currently used processes needing at least 6 high temperature steps. Also, the presently preferred process does not require the use of any photoresist The process steps are briefly summarised below:
1. Etching of saw scratches on the wafer by using 30% Choline solution..
2. Texturing of wafer surface by using 5% Choline solution.
3. Rinsing of the wafer by H₂O to remove residual Choline
4. Drying of the wafer to remove residual H₂O
5. Printing on phosphor silica pattern
6. Diffusing of phosphor (high concentration) at approximately 1000C with gettering with slow cooling and plasma-etch
7. Printing on boron silica pattern
8. Printing on phosphor silica pattern
9. Diffusing of phosphor (low concentration) and boron (high concentration) at approximately 1000C and subsequent plasma-etch.
10. Applying conductors (conductive film) on the phosphor layer and subsequently on the boron layer.

In a further example, said doped areas are formed by using rapid thermal annealing..

Rapid thermal annealing is an efficient method for activating the conductive material. Rapid thermal annealing involves heating the substrate to about 1200K. Typically, a halogen lamp is used for this purpose. It should be noted that the silicon wafer should be cooled slowly to avoid any thermal damage Typically, one heating cycle is needed for each conductive material, thus two heating cycles are needed for two concoctive materials

In a further example said first type dopant is applied before said second type dopant

In this context it has been experimentally shown that when using boron and phosphor as dopants, phosphor diffuses into the boron layer to a very large extent, whereas boron diffuses into the phosphor layer to a much lesser extent. Thus, by applying and diffusing boron into the silicon wafer before applying and diffusing phosphor into the silicon wafer, the effect of cross diffusion may be significantly reduced. Further reduction of cross diffusion is achieved by covering the silicon wafer during the heat treatment. Yet further reduction of cross diffusion is achieved by ventilation.

In a further example, said doped areas are applied by the use of screen printing or alternatively by the use of inkjet printing.

Typically, spin-on is used as a simple and fast method for applying the p-type and n-type material on the silicon wafer. However, spin-on is not suitable for applying different types of conductive material on the same surface, since spin-on covers the whole surface with an equally thick layer of material. Screen printing and inkjet printing are technologies which are used for very accurate application of a material onto a surface. Both screen printing an inkjet printing allows a precise quantity and positioning of the doping material on the wafer surface and allows different conductive materials to be positioned on different parts of the same surface. The accuracy is decisive for achieving the correct functionality of the solar cells and therefore both screen printing and inkjet printing may be used.

In the present context inkjet printing is preferred, since both the dopant and the electrical connectors may be applied by inkjet printing

The above need and object together with numerous other needs and objects, which will be evident from the below detailed descriptions below, are, according to a second aspect obtained by method of producing a high voltage solar cell wafer, said method comprising.
providing a wafer, preferably crystalline silicon, defining a front surface for exposure to solar light and an opposite back surface,
applying a plurality of p-n junctions each exposed to solar light at the front surface,
connecting said plurality of p-n junctions electrically in series for providing a voltage substantially higher than the voltage of a single p-n junction, and, preferably
connecting by-pass diodes parallel to one or more of the p-n junctions.

It is evident that the above method may include any of the features according to the first aspect of the present invention. It is further evident that all of the examples described may equally apply to further aspects described below.

As previously discussed, in a preferred embodiment, applying a plurality of p-n junctions may be performed by the following steps 1-5:
1) printing on phosphor silica pattern,
2) diffusing of phosphor (high concentration) at approximately 1000C with gettering with slow cooling and plasma-etch,
3) printing on boron silica pattern,
4) printing on phosphor silica pattern, and
5) diffusing of phosphor (low concentration) and boron (high concentration) at approximately 1000C and subsequent plasma-etch,

In a further example, the wafer is subjected to rapid thermal annealing during step 9)

In a further example, the following initial steps a-d are performed before performing the above-mentioned steps 1-5.
a) etching of saw scratches on the wafer by using 30% Choline solution,
b) texturing of wafer surface by using 5% Choline solution,
c) rinsing of the wafer by H₂O to remove residual Choline, and
d) drying of the wafer to remove residual H₂O.

The above need and object together with numerous other needs and objects, which will be evident from the below detailed description of an example of the module are according to a third aspect obtained by a solar module, comprising a shallow enclosure, comprising a back plate and a corresponding front plate, the front plate being transparent to solar light, the enclosure further comprising a plurality of solar cell assemblies and a plurality of bypass diode assemblies, all being accommodated between the front and back plates, the plurality of bypass diode assemblies being identical to the plurality of solar cell assemblies and each specific bypass diode assembly having a corresponding solar cell assembly, each of the solar cell assemblies comprising:
one or more solar cell elements of semiconductor-based material exposed to solar light at the front plate, and
   each of the bypass diode assemblies comprising:
a set of parallel- and/or series-connected individual bypass diodes, being separated in relation to each other for allowing residual heat generated by the individual bypass diodes to dissipate, the individual bypass diodes being accommodated juxtaposed with one or more solar cell elements and electrically connected in parallel in relation to one or more solar cell elements for allowing individual bypassing of each of the solar cell assemblies of the plurality of solar cell assemblies.

For allowing a large active surface to receive solar light and still maintain a low profile, the enclosure should be shallow The enclosure comprises a front plate and a back plate and the solar cell assemblies are accommodated between the front and back plates, forming a laminate structure The front plate and the back plate serve as protection for the fragile solar cell assemblies. The front plate should be transparent to light so that the radiate energy in the light may reach the solar cell assemblies The solar cell assembly comprises one or more solar cell elements of semiconductor material. The solar cell elements should be positioned so that the active area, i.e. the p-n junction, is facing the front plate so that the active area may be exposed to solar light when the solar module is in use. Having a set of several bypass diodes being parallel- and/or series-connected, instead of a few large bypass diodes, will allow each individual bypass diode to be smaller, thus, the diodes may be accommodated within the laminate structure in exactly the same way as the solar cell assemblies without any bulging of the laminate structure. Large bypass diodes will cause the laminated structure to bulge and increase the risk of accidental de-lamination of the laminate structure, especially when the bypass diodes are hot during use.

When the solar cell is shaded and assuming the negatively biased state, it will start consuming power, which will be dissipated for the most part in the form of thermal energy, i.e. heat. The thermal energy generated may cause a local hotspot, which may damage the solar module. By including a bypass diode assembly, the current may flow through the bypass diode assembly instead of through the solar cell assembly in case of reverse biasing of the solar cell assembly. The current, which flows through the bypass diode assembly, will still cause some heat due to the power consumed in the bypass diode The bypass diode assembly should, therefore, comprise a set of bypass diodes for distributing the thermal energy and avoiding a local hotspot where the diode is located. Having a set of parallel connected bypass diodes will also provide redundancy in case of a failure of one of the bypass diodes in addition to allowing the heat generated in the bypass diode assembly to be distributed over several individual bypass diodes. The bypass diodes should be separated from each other for distributing the thermal energy and allowing thermal energy to dissipate through the enclosure without causing any damage due to elevated temperatures.

When using metallurgical grade silicon, the increased number of impurities and crystal defects in an individual solar cell element or in the solar cell assembly may cause the solar cell assembly to malfunction Such malfunction may cause the solar cell assembly to consume energy and subjecting the affected solar cell area to overheating In particular, the solar cell assembly may permanently assume a reverse biased state similar to a shaded cell. In such cases permanent bypassing of the solar cell assembly will minimise the negative consequences of a malfunction caused by the use of metallurgical grade silicon

The bypass diode assembly should be juxtaposed with the solar cell elements, i.e. in the spacing between the solar cell elements. The bypass diode may, thus, be easily connected to the solar cell for allowing individual bypassing of each solar cell assembly. The bypass diodes may preferably be applied automatically in connection with the automatic soldering of the current path of the solar cell assembly. The automatic soldering or welding of the current path which interconnects the solar cell element in the solar cell assembly is made by a standard stringer machine well known in the art The stringer machine may as well do the layout of the solar cell assembly as a string of solar cell elements, e.g. to form a string or matrix, and the layout of the bypass diode assembly. The stringer machine may handle bypass diodes and other components the same way as it handles solar cell elements. The stringer machine may at the same time solder or weld the interconnections between the individual solar cell elements and between the solar cell elements and the bypass diodes and other components and thus the inclusion of bypass diodes between the front and back plates will not result in any reduction in production capacity or need for extra equipment.

The bypass diodes will thereby be encapsulated in the same level as the solar cell elements between the front and back plates and protected from moisture and corrosion

By allowing individual bypassing of each solar cell assembly, the consequences of the loss of a single solar cell assembly will be minimised since only the negatively biased solar cell assemblies will be bypassed This feature is of special importance if the solar cell assembly is positioned in a location subjected to high levels of debris, or alternatively when using metallurgical grade silicon where a high rate of solar cell failure may be expected

The solar cell assemblies within the solar module as well as the solar cell element within the solar cell assembly are typically series-connected for achieving a higher voltage than the voltage generated by a single solar cell. Thus, the solar cells within the solar module typically operate at different voltages and, thus, there should not be any galvanic connection between the solar cell assemblies within the solar module, since any galvanic connection between the solar cells may cause a short-circuit Consequently, a small gap must be provided between the individual solar cell assemblies within the solar module The gap may preferably be used to accommodate the bypass diode assembly. This way the bypass diode assembly may be accommodated within the enclosure without making the enclosure significantly larger and without blocking any part of the active surface of the solar cell assembly with the bypass diodes.

In a further example, the bypass diode assembly allows individual bypassing of each of the solar cell elements of the solar cell assembly. In embodiments according to the present invention the solar cell assembly comprises a string of interconnected solar cell elements, where each element comprises a single p-n junction, e.g. series-connected for increasing the voltage of the solar cell assembly. The number of solar cell elements in each solar cell assembly is typically a small number below 20, preferably maximum 10, more preferably below 8, such as 2 or 4. However, in a particular example according to the first aspect, each solar cell element may be individually bypassed. Thus, when a single solar cell element falls out, it may be individually bypassed, and the rest of the solar cell elements in the solar cell assembly will remain unaffected.

In a further example according to the third aspect, the set of individual bypass diodes includes at least 2 individual bypass diodes, such as 2-5, 6-10 or 11-20, preferably 4-10, more preferably 6-8. The above numbers of bypass diodes have been found to be appropriate for achieving proper heat dissipation in most cases

In a further example, the bypass diodes are separated by 1-5 mm and preferably 3 mm. A separation of about 3 mm will allow each bypass diode a sufficient surface for dissipating the generated thermal energy to the outside without any risk of overheating the enclosure or the diode itself

In a further example, the bypass diode assembly is being located at the periphery of the solar cell assembly. To avoid the occurrence of hotspots, the bypass diodes should be distributed over a large area. By distributing the bypass diodes, the effective cooling is increased By accommodating the bypass diode assembly at the periphery of the solar cell assembly, the thermal energy may be efficiently dissipated to the surroundings and the occurrence of hotspots will be avoided. The reception of solar light may be reduced near the periphery of the solar cell assembly, thus making the placement of bypass diodes at the periphery of the solar module particularly advantageous.

In a further example, the bypass diode assembly defines a thickness substantially equal to the thickness of the solar cell assembly. For retaining a low profile shape of the solar module, the thickness of the bypass diode must not substantially exceed the thickness of the solar wafer for preventing any bulges in the enclosure. Commercial available low-profile bypass diodes are preferably used

In a further example, the thickness of the solar cell assembly is about 0.05-1 mm, preferably 0.2 mm. The standard thickness of solar modules is between 0,05 and 2 mm for allowing sufficient rigidity, and at the same time achieving a low weight of the solar module and little material use..

In a further example, the front and back plate of the enclosure may comprise any of the materials glass, polyester or EVA. The front and back plates of the enclosure typically comprise a material, which is transparent for allowing solar light to reach the solar wafer without any considerable absorption losses in the housing. The front plate should be transparent for allowing solar light to enter and impinge the active area of the solar cell assembly The back plate may be transparent, opaque or reflective

The above need and object together with numerous other needs and objects, which will be evident from the detailed description below, are obtained by a solar module, comprising a shallow enclosure, comprising a back plate and a corresponding front plate, the front plate being transparent to solar light, the enclosure further comprising a solar cell assembly being accommodated between the front and back plates, the solar cell assembly comprising:
a solar cell of semiconductor-based material exposed to solar light at the front plate,
a piezoelectric alarm, being powered by the solar cell or solar cell assembly and/or the energy storage unit, the piezoelectric alarm being adapted for generating a sound pressure level of at least 100dB at a distance of 1 m from the solar module, and
a control circuitry, being connected between the solar cell or solar cell assembly and the piezoelectric alarm for activating the piezoelectric alarm when the solar module has been removed from its installed location without any prior authorisation

The piezoelectric alarm inside the solar module will deter anyone from trying to remove the solar module without authorisation. The thief would be unable to use the module when the alarm has been initiated, and the acoustic noise generated by the piezoelectric alarm will alert law enforcement officers to the location of the solar module The sound level of at least 100dB may additionally prevent the thief from continuing the attempt of removing the solar module The piezoelectric alarm may further be configured to deactivate the solar module when any theft attempt has been made. Since the piezoelectric alarm is integrated into the enclosure between the front plate and the back plate, any ad hoc attempt of disabling the piezoelectric alarm would be particular cumbersome and would most probably result in the solar module breaking before the alarm is turned off In particular, the area where the piezoelectric alarm is integrated may be laminated with either a glass plate or a metal plate so that the piezoelectric alarm cannot be separately removed without breaking the solar module..

In a further example, the solar cell or solar cell assembly may comprise an energy storage unit, being connected to the solar cell or solar cell assembly for storing at least part of the electrical energy generated in the solar cell. Typically, an energy-storing unit is not needed, since the piezoelectric alarm may be powered directly by the solar cell or solar cell assembly. However, in some embodiments the energy storage unit may comprise a flat, rechargeable battery or the like for storing electrical energy needed to power the piezoelectric alarm Since most thefts occur at night, powering the piezoelectric alarm directly from the solar cell will not be appropriate in all cases. The control circuitry is used for activating the piezoelectric alarm in case the solar module is removed from its installed location. The activation involves directing electrical energy from the energy storage unit to the piezoelectric alarm

Solar modules are normally provided as an arrangement including large numbers of electrically connected modules The piezoelectric alarm may be initiated when the control circuitry determines that the solar module is disconnected from the assembly. Alternatively, the solar module may be provided with a motion sensor.. The control circuitry may require a code to be provided before allowing use of the solar module when the solar module has been removed from its original location. The code is preferably provided by entering a numeric combination on a keypad by holding a RFID tag near the solar module or by any similar authorisation method. By providing the code, the subsequent removal of the solar module is regarded as being authorised and the alarm will not be initiated

The above need and object together with numerous other needs and objects, which will be evident from the below detailed description, are obtained by a solar module, comprising a shallow enclosure, comprising a back plate and a corresponding front plate, the front plate being transparent to solar light, the enclosure further comprising a solar cell assembly being accommodated between the front and back plates, the solar cell assembly comprising:
a solar cell of semiconductor-based material exposed to solar light at the front plate, and
an energy storage unit for storing at least part of the electrical energy generated in the solar cell or solar cell assembly, the energy storage unit being electrically connected to the solar cell or solar cell assembly, and when the solar module is in use, the electrical storage unit selectively assuming either a storing mode, in which electrical energy is transported from the solar cell or solar cell assembly to the electrical storage unit when the solar cell is exposed to solar light, or a delivering mode, in which electrical energy is transported from the storage unit to the solar cell or solar cell assembly for generating visual light

An energy storing unit such as a flat, rechargeable battery or capacitor or the like may be provided for storing excessive electrical energy when the solar module is subjected to light.

When the solar module is not subjected to solar light or when the energy from the incoming light is very small, the battery or capacitor may be used for delivering power back to the solar module. By providing current to the solar cells, the solar cells may be caused to emit light, which may be visible during low light conditions such as at night Thus, the electrical storage unit described above may be used as a light-generating device at night powered by environmentally friendly solar energy collected during the day.

The electrical storage unit should be included in the enclosure between the front plate and the back plate. A common electrical storage unit may be connected to several solar cells. When the electrical storage unit assumes the storing mode, electrical power flows towards the electrical storing unit for charging the electrical storing unit. When the electrical storage unit assumes the delivering mode, the electrical energy previously collected will return to the solar cell and cause the solar cell to emit light.

In a further example, the electrical storage unit comprises a photo detection unit for determining whether the electrical storage unit should assume the storing mode or the delivering mode, the photo detection unit determining the storing mode to be assumed when the exposure to solar light exceeds a critical value, and the delivering mode when the exposure to solar light does not exceed the critical value. In this way the solar module will automatically start emitting light when the solar module is shaded, i.e. at night During the daytime the solar module will collect energy as previously described.

In a further example, the electrical storage unit comprises a control unit, when in the delivering mode the control unit selectively allows or prevents electrical energy to be transported from the storage unit to the solar wafer for generating a specific light pattern. The pattern may be used at nighttime for artistic, commercial or similar purposes It is contemplated that further electronic devices may be incorporated into the solar module and in particular the control unit. Such electronic devices may e.g. include a DC/AC converter for the solar module to provide AC output current.. By electronic devices is meant any discrete component or circuitry as well as IC component providing a substantial amount of intelligence into the solar module

The above need and object together with numerous other needs and objects, which will be evident from the below detailed description, are obtained by a method of manufacturing a solar module by providing:
a shallow enclosure, comprising a back plate and a corresponding front plate, the front plate being transparent for exposure to solar light,
a plurality of solar cell assemblies, comprising one or more solar cell elements of semiconductor based material, and
a plurality of bypass diode assemblies, the plurality of bypass diode assemblies being identical to the plurality of solar cell assemblies, and each specific bypass diode assembly having a corresponding solar cell assembly, the plurality of bypass diode assemblies comprising a plurality of parallel- or series-connected individual bypass diodes being separated in relation to each other for allowing residual heat generated by the individual bypass diodes to dissipate,
the method further comprising performing the following steps;
encapsulating the solar cell assemblies within the enclosure between the front plate and the back plate and exposing the solar cell elements to solar light at the front plate, and
accommodating the bypass diode assembly juxtaposed with the solar cell elements and electrically connecting the bypass diode assembly in parallel in relation to one or more solar cell elements for allowing individual bypassing of each of the solar cell assemblies.

It is evident that the above method may be used together with any of the previous examples.

The present invention will now be further described with reference to the drawings, in which.
Fig 1 a-b is a square semiconductor based wafer from a front and side view, respectively
Fig 2a-b is a bifacial circular semiconductor based wafer from a front and back view
Fig 2c is a single sided circular semiconductor based wafer from a front view
Fig 3 a-c is a screen printing pattern.
Fig 4 is a semiconductor based wafer where the p-n junctions are located on the front surface
Fig 5 is a semiconductor based wafer where the p-n junctions are encapsulated, and
Fig 6 is a semiconductor based wafer where the p-n junctions are oriented perpendicular to the front surface.
Fig 7a is a first and presently preferred example of a solar module,
Fig 7b is a further example of a solar module,
Fig 7c is a perspective view of a solar module,
Fig 8a is a solar cell arrangement,
Fig 8b is a forward biased solar cell,
Fig 8c is a backward biased solar cell,
Fig 9a-b is a piezoelectric alarm module,
Fig 10a-b is a solar assembly of solar modules during the daytime and a close-up, respectively, and
Fig 10c-d is a solar assembly of solar modules at nighttime and a close-up, respectively

Below follows a detailed description of preferred examples according to the present invention.

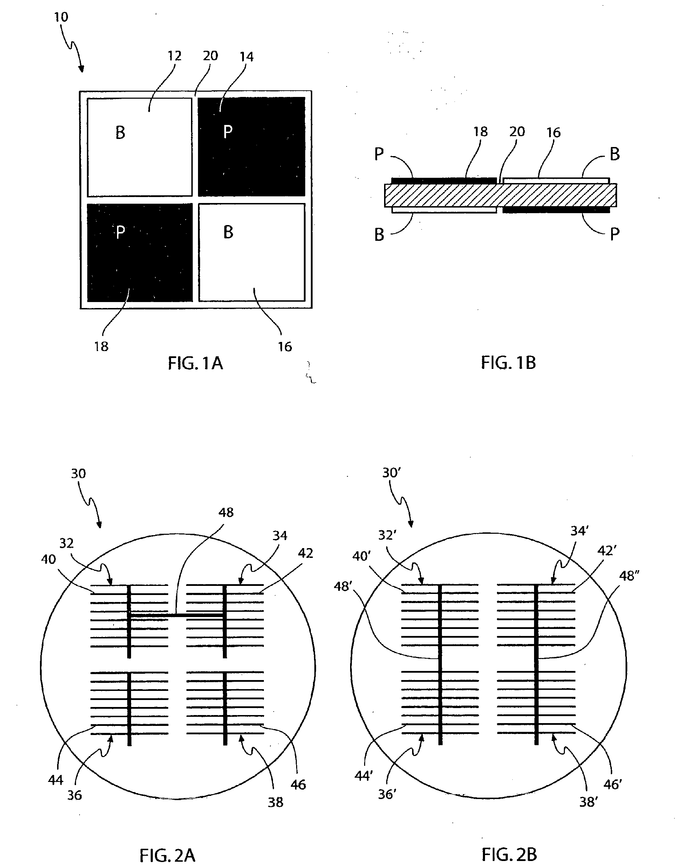

Fig 1a shows a front surface view of a square semiconductor based wafer 10. The semiconductor based wafer 10 comprises four p-n junctions. The semiconductor based wafer 10 will thus yield four times the voltage compared to a standard single p-n junction wafer The front surface of the semiconductor based wafer has four square and equally sized doped areas 12, 14, 16, 18. Two of the doped areas 12, 16 constitute p-type silicon material and the other two doped areas 14, 18 constitute n-type material The n-type doped areas have been doped with phosphor (P) atoms, while the p-type doped areas have been doped with boron (B) atoms. The four doped areas 12, 14, 16, 18 are arranged in two rows and two columns, each row and column comprising an n-type doped area and a p-type doped area, respectively. The four doped areas 12, 14 ,16, 18 are thus arranged in an alternating pattern, i.e. each of the two n-doped areas 14, 18 are arranged adjacent to the two p-type areas 12, 16 and each of the two p- type areas 12, 16 are arranged adjacent to the two n-type areas 14, 18 so that a chess board pattern is formed The rows and columns of the four doped areas 12, 14, 16, 18 are separated by a small strip 20 of non-doped silicon material, so that no direct contact between the four doped areas 12, 14, 16, 18 is present.

Fig 1b shows a side view of the previously described square silicon wafer 10. The current view shows both the front surface and the back surface of the silicon wafer 10 The present view reveals the back surface of the silicon wafer 10, which has a pattern of doped areas representing a mirror image of the front surface Each of the doped areas on the front surface has an oppositely doped area on the back surface, i.e. an area of n-type material on the front surface has an opposite area of p-type material on the back surface and each of the doped areas on the front side having p-type material have an opposite area of n-type on the back surface Thus, the silicon wafer 10 wafer comprises four solar cells 12, 14, 16, 18 in which two of the solar cells 12, 16 are oppositely oriented compared to the other two solar cells 14, 18

On p-type silicon, the design consists of an alternation between p+pn+ and n+pp+ areas, where the phosphorous emitter is on the front and back of the wafer, respectively. By using a boron back-surface field, the semiconductor based wafer becomes transparent so that, when the emitter is on the bottom of the silicon wafer, light may pass into the solar cell, and when the emitter is on the top of the silicon wafer, non-absorbed light may be reflected back into the semiconductor based wafer

The present technology involves using both p-type and n-type doped areas 12, 14, 16, 18. The n-type doped areas 14, 18 are applied by diffusing phosphor (n-type material) atoms into the silicon wafer 10 and n-type doped areas 12, 16 are similarly applied by diffusing boron (p-type material) atoms into the silicon wafer 10. The process steps used has been described above A technique based on screen printing has been developed for the area-selective application of boron and phosphorus diffusion sources. The diffusion may be performed by rapid thermal annealing, as already discussed above.

The silicon wafer 10 may alternatively be an intrinsic silicon wafer Thus, the doped areas 12 and 16 will be doped with p-type material (boron atoms) on the front surface and n-type material (phosphor atoms) on the back surface Alternatively, an n-type wafer may be used for achieving n+np+ and p+nn+ cells.

Fig 2a shows the front surface of a circular semiconductor based wafer 30 according to the present invention The semiconductor based wafer 30 is made of intrinsic p-type material having four solar cells 32, 34, 36, 38 which have been produces in a similar way as described in connection with fig 1. The front surface of the solar cells designated 32 and 38 constitutes p-doped areas and the front surface of the solar cells designated 34 and 36 constitutes n-type areas Each of the solar cells 32, 34, 36, 38 on the semiconductor based wafer has a contact grid 40, 42, 44, 46 respectively The contact grids 40, 42, 44, 46 constitute a metal grid of tin coated copper band on top of the doped areas 32, 34, 36, 38 This technique is well known in the art of solar cell manufacturing The individual solar cells 32, 34, 36, 38 are joined by tin coated copper band to form a series connection. On the front surface the solar cell designated 32 is electrically connected to the adjacent solar cell 34 by tin coated copper band 48

Fig 2b shows the back surface 30' of the above circular semiconductor based wafer 30. The back surface of the solar cells designated 32' and 38' constitutes n-doped areas and the front surface of the solar cells designated 34' and 36' constitutes p-type areas. The back surface the solar cells designated 32' is electrically connected to the adjacent solar cell 36' and the solar cell 34' is electrically connected to the adjacent solar cell 38' by tin coated copper band 48', 48" respectively Thus, the four solar cells 32, 34, 36, 38 are electrically connected by a series connection which effectively yields a total voltage of the semiconductor based wafer 30' as the voltage of a single cell multiplied with the number of cells which in this case is four.

Fig 2c shows a single sided circular semiconductor based wafer 30". The back surface of the solar cells designated 32" and 36" constitutes n-doped areas and the front surface of the solar cells designated 34" and 3'8' constitutes p-type areas forming an alternating pattern. The four solar cells 32", 34", 36", 38" are electrically connected by a series connection which effectively yields a total voltage of the semiconductor based wafer 30" as the voltage of a single cell multiplied with the number of cells which in this case is four. The four solar cells 32", 34", 36", 38" are electrically connected by contact grids 40", 42", 44", 46" which constitute a metal grid of tin coated copper band of one 1 mm band in the longitudinal direction and twelve 0.1mm bands in the transversal direction for each solar cell 32", 34", 36", 38".

The maximum voltage is provided on the front surface of the above circular silicon wafer 30 between solar cell 36 and 38. To avoid cross diffusion, a small distance should be left without doping between the solar cells 32, 34, 36, 38

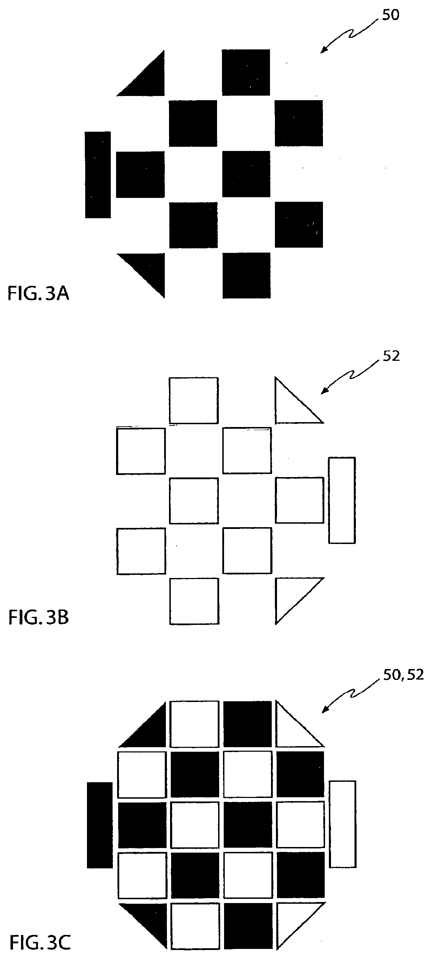

Fig 3 shows a silicon wafer comprising a plurality of p-type and n-type areas. The p-type and n-type material may be applied by using screen printing. The material used for screen printing is a silica material comprising either boron or phosphor atoms for creating either p-doped areas or n-doped areas, respectively.

Fig 3a shows the pattern 50 used for printing boron silica material, fig 3b shows the pattern 52 for printing phosphor silica and fig 3c shows the result from printing both the boron pattern 50 of fig 3a and the phosphor pattern 52 of fig 3b. To avoid cross diffusion between the boron and phosphor layers, a small undoped area is left between the boron and phosphor areas

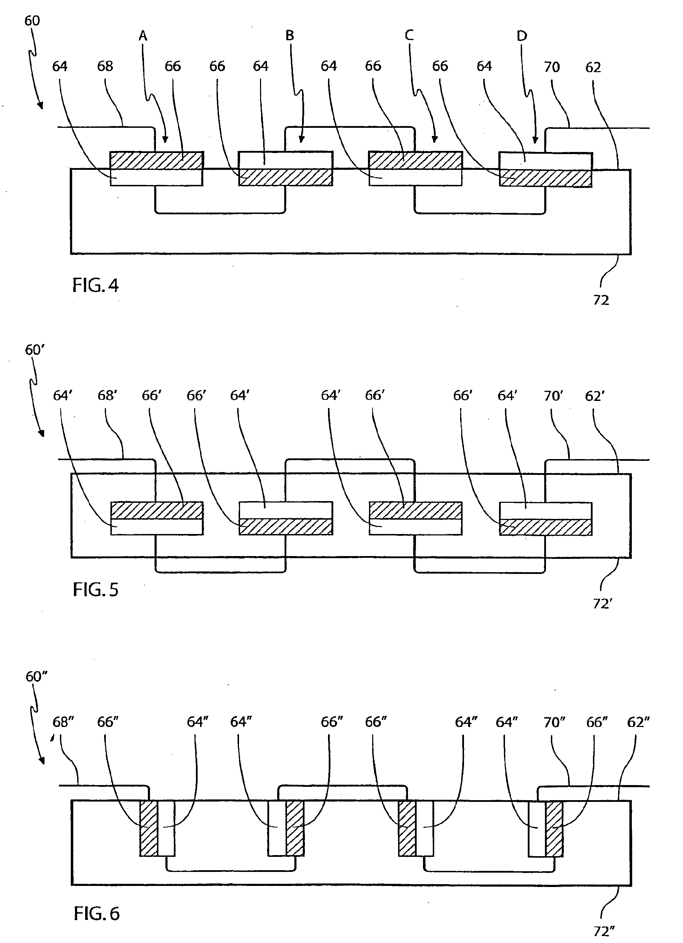

Fig 4 shows a single sided semiconductor based wafer 60 comprising a silicon wafer The semiconductor based wafer 60 comprises a front surface 62 having alternating layers of boron 64 and phosphor 66 forming 4 p-n junctions, where 2 p-n junctions have the boron 64 layer facing upwards and the phosphor 66 layer facing downwards, and 2 p-n junctions having the boron 64 layer facing downwards and the phosphor 66 layer facing upwards. The p-n junctions are connected in series by a conductor 68 The conductor connects the upper phosphor layer of the first p-n- junction A to the outside. The lower boron layer of the first p-n-junction is connected to the lower phosphor layer of p-n-junction B inside the semiconductor based wafer 60 The upper boron layer of p-n- junction B is connected on the surface of the semiconductor based wafer 60 to the phosphor layer of p-n junction C The lower boron layer of p-n junction C is connected to the lower phosphor layer of p-n-junction D inside the silicon wafer 62 and finally the upper boron layer of the p-n junction D is connected to the outside at 70. The connectors 68 and 70 may be soldered to other electrical equipment for consuming the power generated by the semiconductor based wafer 60. The back surface 72 of the silicon wafer 62 may be reflective to reflect the radiation back towards the p-n-junctions.

Fig 5 shows a semiconductor based wafer 60' similar to the semiconductor based wafer 60, however in the present embodiment the boron 64' and phosphor 66' layers are completely encapsulated within the semiconductor based wafer 60'. The conductor 68' may be located on the front and back surface or alternatively inside the silicon wafer.

Fig 6 shows a semiconductor based wafer 60" similar to the semiconductor based wafer 60, however in the present embodiment the boron 64" and phosphor 66" layers are oriented perpendicular in relation to the front surface 62" of the semiconductor based wafer 60".

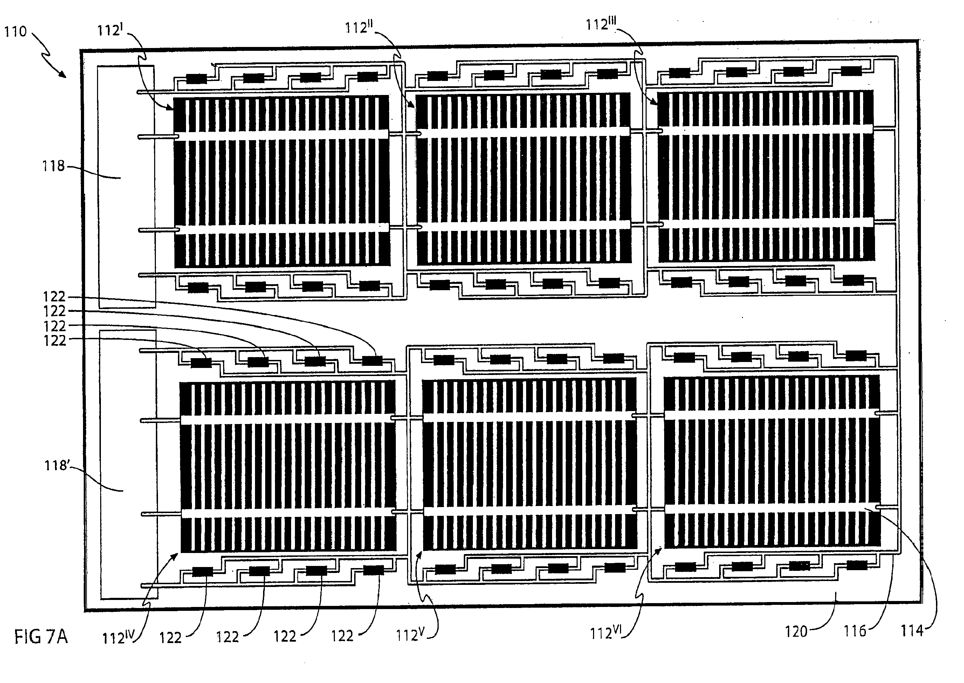

Fig 7a shows a top view of a solar module 110, comprising six solar cell elements 112. The solar cell elements 112 constitute a thin plate made of mono-crystalline or polycrystalline silicon, which has been doped with a doping material to form a p-n junction A separate conductor grid 114 is applied to the upward and downward surface of the solar cell element 112, respectively. Conductor strips 116 connect the six solar cell elements 112 in a series connection so that the downwardly facing conductor grid (not visible) of the first solar cell element 112^{I} is connected to the upwardly facing conductor grid 114 of the subsequent solar cell element 112^{II}. The other solar cell elements 112^{II}-112^{VI} are connected likewise The first solar cell element 112^{I} and the sixth solar cell 112^{VI} are connected to a plus terminal 118 and a minus terminal 118'. The conductor grids 114 and conductor strips 116 constitute thin metal strips. By connecting the solar cell elements 112 in series as shown in fig 7a, a higher voltage is generated between the terminals 118, 118' than would be generated by a single cell 112 or a plurality of parallel-connected solar cell elements 112 Each cell typically generates a maximum voltage of about 05V. Thus, the solar module 110 will generate a maximum voltage of about 3V Several solar modules 110 may be connected in series for even higher voltage output The solar cell elements 112 and conductor strips 116 are accommodated on a back plate 120. The back plate is either made of glass, polyester, EVA or a similar material. The back plate 120 may be coated with a reflective layer to reflect any incoming radiation back to the solar cell elements 112. The back plate 120 should be made rigid for protecting the fragile solar cell elements 112.

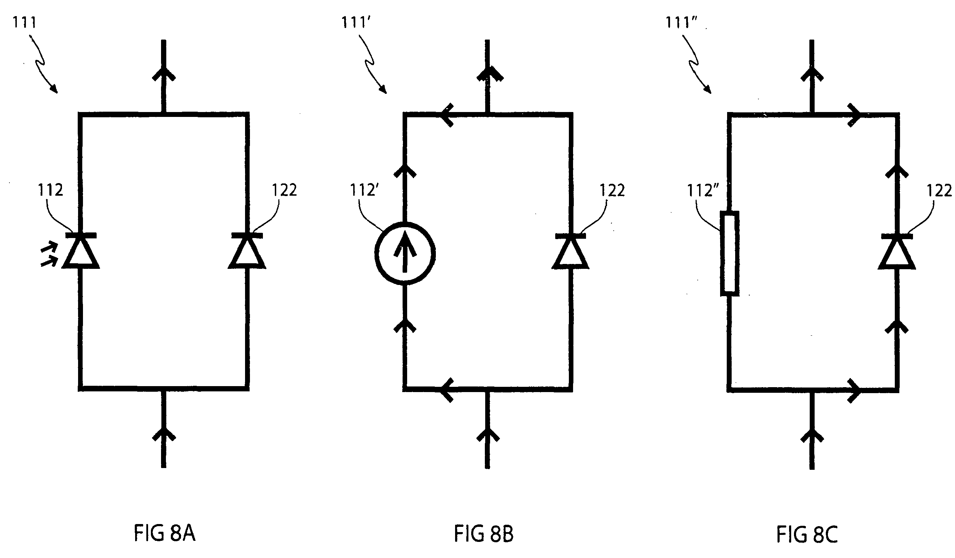

The solar cells must not overlap and a sufficient space must be provided on each side of the solar cell elements 112 for avoiding short-circuit with nearby solar cells. The space may be used for accommodating bypass diodes. Each of the solar cell elements 112 has eight parallel-connected small bypass diodes 122, which are distributed on each side of the solar cell and form a bypass diode assembly effectively acting as a single large bypass diode, however, distributing the heat generated by the bypass diodes 122 over a larger surface and allowing the individual bypass diodes 122 to be smaller. The bypass diodes 122 protect the solar cell in case of malfunction or shading. The function of the bypass diodes 122 will be described in detail later in connection with Fig 8 By distributing the bypass diodes 122, the thermal energy generated in each bypass diode will be distributed for avoiding overheating and hotspots, which may permanently damage the solar module 110 A plurality of bypass diodes also provides redundancy in case of a failure in one of the bypass diodes It is further contemplated that additional bypass diodes may be connected in parallel in relation to the solar cell element 112 for additional thermal distribution and redundancy

The above configuration allows individual bypassing of a faulty solar cell element 112. Thus, the voltage loss due to a malfunctioning solar cell element 112 will be limited to the single cell element and the rest of the solar module 110 will continue to work as intended. This feature is particularly important when using silicon material of a lesser quality than solar grade, such as metallurgical grade The failure rate of metallurgical grade silicon exceeds by far the failure rate of solar grade silicon. However, taking into account its significantly lower price, for some commercial applications it may be contemplated to use metallurgical grade silicon instead of solar grade silicon, as long as the failure of a single cell is restricted to a loss of voltage corresponding to the single cell, and the other functioning cells remain unaffected The bypass diodes 122 are connected by using conductor strips of the same type as used for connecting the solar cell elements 112, and designated the reference numeral 116 It is contemplated that for some applications it may be desired to use a plurality of bypass diodes 122 connected in series with a set of solar cell elements 112, such as 2, 4, 8, 16 or 32 solar cell elements 112

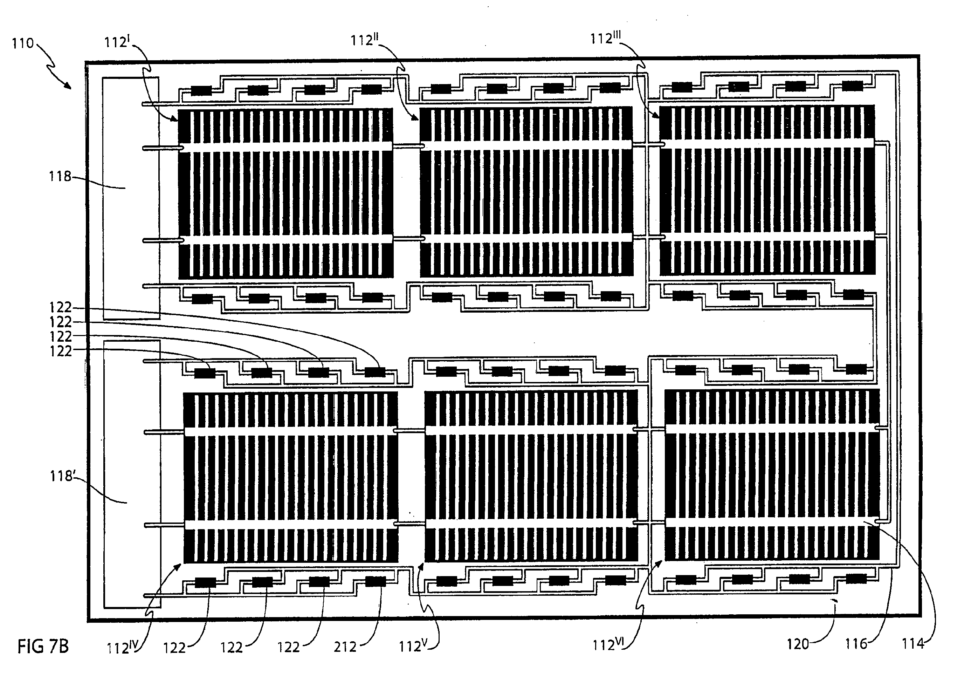

Fig 7b shows a top view of a solar module 110 as shown in Fig 7a, however, some of the individual solar cell elements 112 are series-connected, i.e. the solar cell elements 112 having the indexation I-II, III-IV and V-VI, respectively. Such configuration, where several of the solar cell elements 112 are connected to form a solar cell assembly, is typically referred to as a solar cell string.. By series-connecting a number of solar cell elements 112, a solar cell having a higher voltage may be achieved. It should, however, be noted that a breakdown or malfunction of a solar cell element 112 typically renders the whole solar cell string or assembly inoperable, thus, the number of solar cell elements 112 in each string should be low

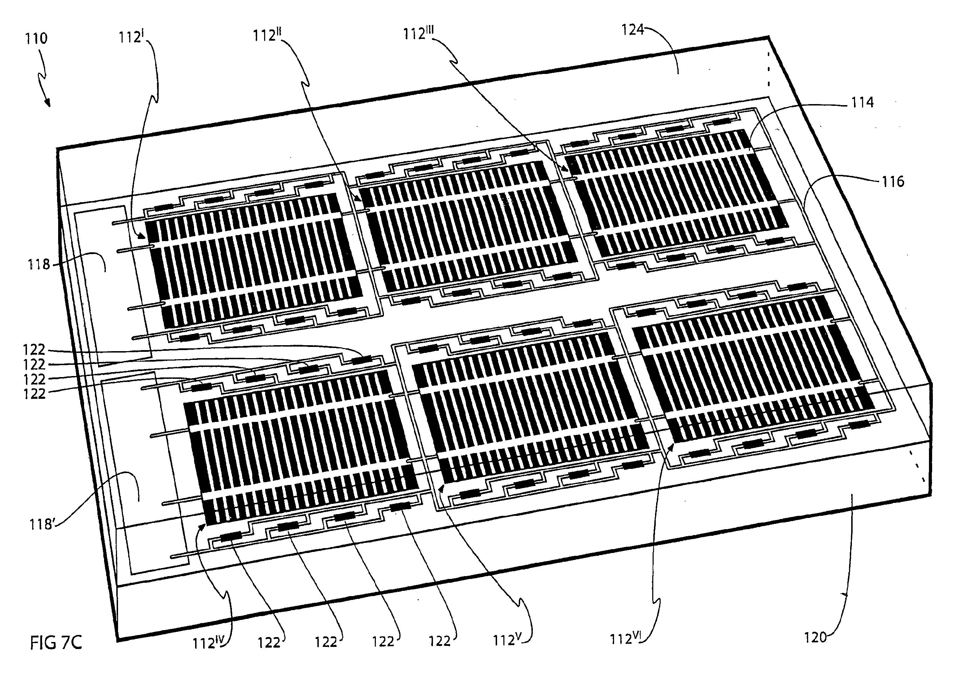

Fig 7c shows a perspective view of the solar module 110 as shown in Fig 7a The solar cell elements 112 are accommodated between a back plate 120 and a front plate 124. The front plate is made of a light-permeable material, preferably glass, polyester or EVA or any similar material having some heat-conductive properties for transporting residual heat from the bypass diodes 122 to the outside. The bypass diodes 122 are low-profile diodes having a thickness corresponding to the thickness of a solar cell element 112. The thickness is typically less than 1 mm, such as 0.2mm. In this way the solar cell element 112 and the bypass diode 122 form an even surface, which simplifies the application of the front plate 124 and gives the solar cell a more attractive exterior The bypass diode 122 may preferably be located near the outer periphery of the back plate 120 Typically, a space of 1-3mm is provided between the solar cell element 112 and the outer periphery of the back plate 120. By placing the bypass diodes 122 near the outer periphery of the back plate 120, residual heat may be conducted more efficiently to the outside of the solar module 110 Moreover, the periphery of the solar module is typically shaded from solar light since it is used for accommodating a framing or similar structure for keeping the solar module assembled and for mounting purposes It is contemplated that for large solar modules 110 the spacing between solar cells may as well be used for bypass diodes 122, as illustrated in the present embodiment.

Fig 8 shows the two different operational modes of the solar cell, the power generation mode and the bypassing mode.

Fig 8a shows a solar module 110' comprising a solar cell element 112 being connected in series with a bypass diode 122.

Fig 8b shows the solar module 110" of Fig 8a in the power generation mode. In the power generation mode the solar cell is forward biased and the bypass diode is negatively biased.. In the power generation mode, the solar cell 122' constitutes a voltage source driving a current and generating power The generating mode is automatically assumed when solar radiation irradiates a functional solar cell and causes a voltage between the poles of the solar cell. The current flows through the solar cell as shown and the bypass diode will become negatively biased and, thus, will not conduct any current.

Fig 8c shows the solar module 110"' of Fig 8a in the bypassed mode In the bypassed mode, the solar cell is forward biased and the bypass diode is negatively biased In the bypassed mode, the solar cell 122" constitutes an electrical resistance, and, thus, the current will take the alternative path through the bypass diode The bypassed mode will be automatically assumed when the solar cell is shaded, i.e. not irradiated by radiation The bypassed mode is also assumed when the solar cell is malfunctioning The solar cell may malfunction due to wear, however, most commonly due to impurities within the silicon Such malfunctions are much more likely when using metallurgic silicon. However, the lower price of metallurgic silicon may make it economically attractive to use, however, always in combination with bypass diodes. The bypass diode then assumes positive biasing and will become conductive for allowing the current to bypass the solar cell, thereby avoiding any overheating of the solar cell, which may lead to power loss as well as malfunction of the whole solar module.

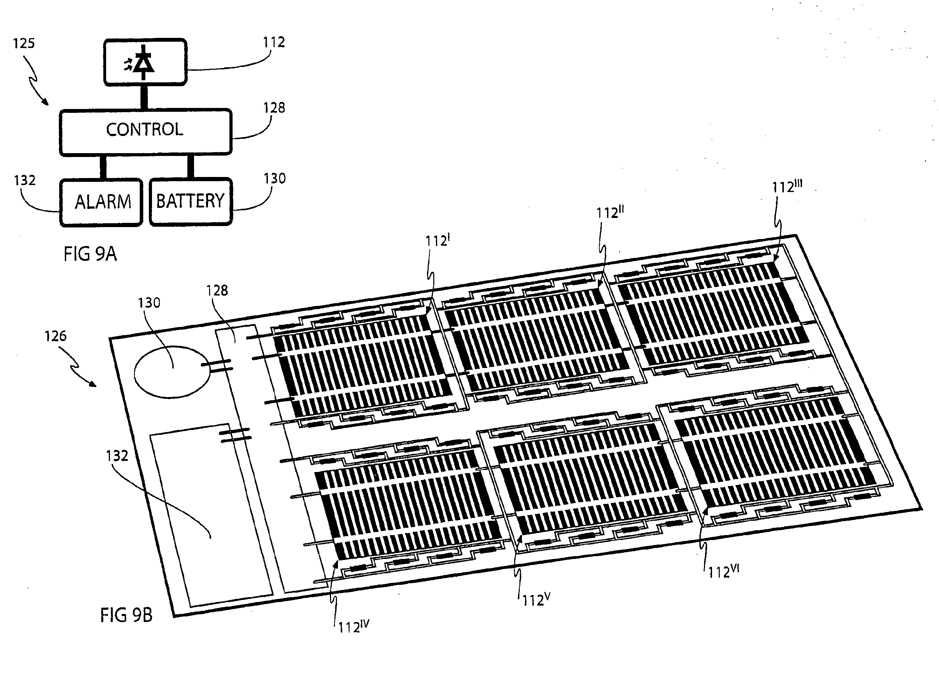

Fig 9a shows a flow chart diagram 125 of a safety module 126, including a piezoelectric alarm system 132. The safety module includes at least one solar cell element 112, being connected to a control board 128. The control board 128 is further connected to a flat, rechargeable battery 130, which is charged during the daytime and provides energy at nighttime. The control board 128 is further connected to the piezoelectric alarm system 132. The piezoelectric alarm system may include a piezoelectric crystal and a resonance circuit of about 400-4000Hz for achieving an audible acoustic signal of at least 100dB at a distance of 1 m from the alarm The control board 128 may include a motion detector, which triggers the alarm Alternatively, connection may be provided with a neighbouring module for enumerating neighbours, such that when one module is removed, the alarm of all of the adjacent modules is triggered as well The control unit should provide means for shutting down the alarm system, such as the ability to provide a code, either by an external computer or keyboard being connected to the safety module via cable, or remotely via an RDIF tag.

Fig 9b shows a perspective view of the safety module 126. The control board 128, the battery 130 and the piezoelectric alarm 132 are all laminated between the front and back plates and accommodated beside the solar cell elements 112. Thereby, an unauthorised person will have to break the module to be able to turn off the alarm.

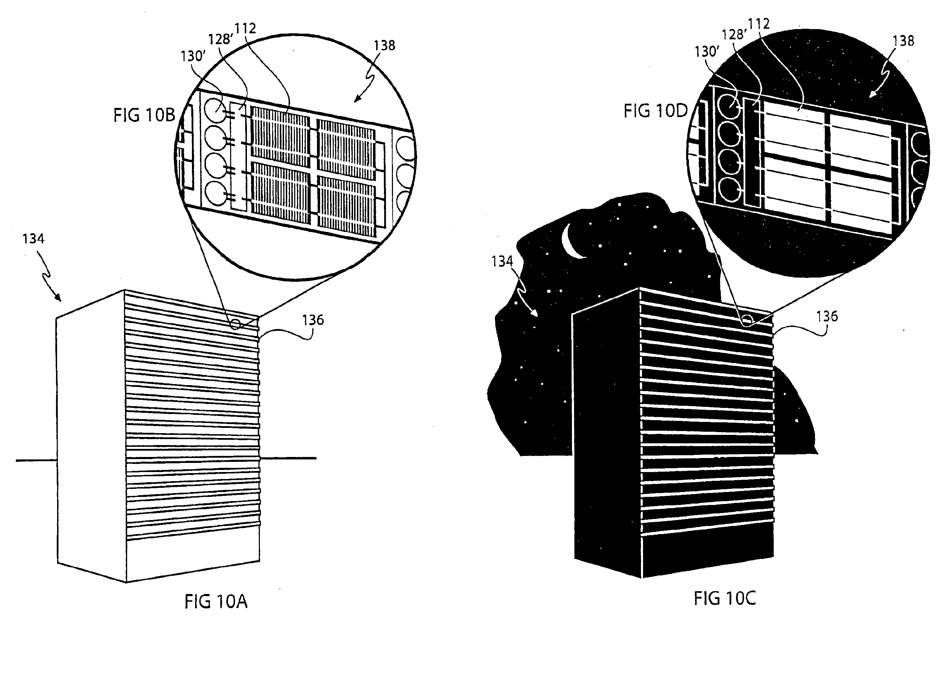

Fig 10a shows a solar array 136, comprising a set of self-illuminating solar modules 138 mounted on the facade of a building 134 during the daytime. The self-illuminating solar modules 138 will be described later in connection with Fig 10b. During the daytime, the self-illuminating solar modules 138 provide shading to the building while collecting solar light and storing the generated electrical energy. The self-illuminating solar modules 138 may be configured as solar shades, which may be pivoted for preventing excessive solar light from entering the windows of e.g. an office building. Alternatively, the windows themselves may be provided with solar cells or constitute solar cells.

Fig 10b shows a close-up view of the solar array of Fig 18a. The solar module 138 comprises a plurality of solar cell elements 112 connected to a control board 128', which charges one or more rechargeable batteries 130'. The control board 128' may assume a charging mode and a discharging mode The control board 128' comprises a circuit board having the same thickness as the solar cell During the daytime, the control board assumes the charging mode, thus, electrical energy is flowing from the solar cells to the batteries.

Fig 10c shows the solar array 136 of Fig 10a at nighttime The energy, which has been stored in the batteries during the daytime, may be sent back to the solar cells at night for achieving a visual effect. The solar array will, thus, glow, giving a pleasant illumination of the building 134 and the near surroundings The solar array 136 may, thus, be used as a facade illumination for exposing the building 134 at night and improve the appearance of the neighbourhood Further, the solar array may be used to illuminate the sidewalk or even as a replacement for street lamps The solar array 136 may also be configured to generate a specific pattern for artistic purposes.. Alternatively, commercial messages may be delivered via the solar array 136

Fig 10d shows a close-up view of the solar array of Fig 10c. The solar cell elements 112 are illuminated by drawing electrical energy from the batteries 130' to the solar cell elements 112 via the control board 128'. The energy stored in the batteries 130' has been collected from solar radiation during the daytime Thus, the present embodiment provides an environmentally friendly alternative to externally powered light sources for illuminating buildings At nighttime the control board 28' assumes discharging mode

The control board 128' may be configured to change from charging mode to discharging mode at a specific time, or preferably the control board 128' is equipped with a light sensor, changing from charging mode to discharging mode when the light intensity falls below a certain level. Yet alternatively, a voltage sensor may be used for changing from charging mode to discharging mode when the output voltage of the solar cells falls below a certain level. The control board 128' may further provide a protection circuit for eliminating the risk of overstressing the solar cells during charging and discharging.

### List of parts with reference to figures 1-6:

10. Square semiconductor based wafer
12, 14, 16, 18. Doped areas
20, non doped strip
30. Circular semiconductor based wafer
32, 34, 36, 38. Doped areas
40, 42, 44, 46 Contact grid
48 Copper band
50. Boron pattern
52. Phosphor pattern
60. Semiconductor based wafer
62. Silicon wafer
64. Boron layer
66 Phosphor layer
68. First conductor
70. Second conductor
72. Reflective back surface

### List of parts with reference to fig 7-10

110 Solar module
112. Solar cell element
114. Conductor grid
116. Conductor strips
118 Terminal
120. Back plate
122. Bypass diode
124. Front plate
125 Flow chart diagram
126. Safety module
128 Control board
130. Rechargeable battery (flat)
132. Piezoelectric alarm system
134. Building facade
136. Solar array
138. Self-illuminating solar module

### POINTS

1. A high voltage semiconductor based wafer defining a front surface for exposure to solar light and an opposite back surface, said semiconductor based wafer including a plurality of p-n junctions each exposed to solar light at said front surface, said plurality of p-n junctions being electrically connected in series to provide a voltage substantially higher than the voltage of a single p-n junction, wherein said semiconductor based wafer comprises by-pass diodes.
2. The method according to point 1, wherein the total voltage of said semiconductor based wafer is substantially equal to the voltage of a single p-n junction multiplied with the number of p-n junctions on said semiconductor based wafer.
3. The semiconductor based wafer according to any of the preceding points, wherein said semiconductor based wafer comprises 2-1000 p-n junctions, preferably 10-500 p-n junctions, more preferably 50-200 p-n junctions, and most preferably 144 p-n junctions, or alternatively 50-144 p-n junctions or 144-200 p-n junctions.
4. The semiconductor based wafer according to any of the preceding points, wherein said p-n junctions are encapsulated within said semiconductor based wafer and/or said p-n junctions are located on said front surface and/or said p-n junctions are located on said back surface.
5. The semiconductor based wafer according to any of the preceding points, wherein said semiconductor based wafer comprises metallurgical grade silicon.
6. The semiconductor based wafer according to any of the preceding points, wherein said semiconductor based wafer comprises:
   a first p-n junction defining a first doped area of a first type and a second doped area of a second type, said first p-n junction defining a first current path,
   a second p-n junction electrically isolated in relation to said first p-n junction and defining a third doped area of said second type and a fourth doped area of said first type, said second p-n junction defining a second current path, and
   a metal layer for electrically connecting said first doped area and said third doped area or alternatively said second doped area and said fourth doped area so that said first and second current paths form a series connection.
7. The semiconductor based wafer according to point 6, wherein said first type comprises either a boron, an arsenic or an atom group III material dopant and said second type comprises either a phosphor, a gallium or an atom group IV material dopant.
8. The semiconductor based wafer according to any of the points 6-7, wherein said first doped area of said first type is oriented towards said front surface, said a second doped area of said second type is oriented towards said back surface, said third doped area of said second type is oriented towards said front surface and said fourth doped area of said first type is oriented towards said back surface.
9. The semiconductor based wafer according to any of the points 6-8, wherein said third and fourth doped areas are connected to further semiconductor based wafers, or other electrical components, by the use of substantially two soldering points for each semiconductor based wafer.
10. The semiconductor based wafer according to any of the points 6-9, wherein said first type dopant is applied before said second type dopant.
11. The semiconductor based wafer according to any of the points 6-10, wherein said active areas are applied by the use of screen printing or alternatively by the use of inkjet printing
12. A method of producing a high voltage solar cell wafer, said method comprising:
   providing a wafer, preferably crystalline silicon, defining a front surface for exposure to solar light and an opposite back surface,
   applying a plurality of p-n junctions each exposed to solar light at said front surface,
   connecting said plurality of p-n junctions electrically in series to provide a voltage substantially higher than the voltage of a single p-n junction, and, preferably
   connecting by-pass diodes parallel to one or more of said p-n junctions.
13. The method according to point 12, wherein said applying a plurality of p-n junctions is made by performing the following steps 1-5:
   1) printing on phosphor silica pattern,
   2) diffusing of phosphor (high concentration) at approximately 1000C with gettering with slow cooling and plasma-etch,
   3) printing on boron silica pattern,
   4) printing on phosphor silica pattern, and
   5) diffusing of phosphor (low concentration) and boron (high concentration) at approximately 1000C and subsequent plasma-etch,
14. The method according to point 13, wherein said wafer is subjected to rapid thermal annealing during step 9).
15. The method according to any of the points 13 and 14, further comprising performing the following initial steps a-d before performing said steps 1-5:
   a) etching of saw scratches on the wafer by using 30% Choline solution,
   b) texturing of wafer surface by using 5% Choline solution,
   c) rinsing of the wafer by H₂O to remove residual Choline, and
   d) drying of the wafer to remove residual H₂O.
16. A solar module, comprising a shallow enclosure, comprising a back plate and a corresponding front plate, said front plate being transparent to solar light, said enclosure further comprising a plurality of solar cell assemblies and a plurality of bypass diode assemblies, all being accommodated between said front and back plates, said plurality of bypass diode assemblies being identical to said plurality of solar cell assemblies and each specific bypass diode assembly having a corresponding solar cell assembly, each of said solar cell assemblies comprising:
   one or more solar cell elements of semiconductor based material exposed to solar light at said front plate, and
      each of said bypass diode assemblies comprising:
   a set of parallel- and/or series-connected individual bypass diodes, being separated in relation to each other for allowing residual heat generated by said individual bypass diodes to dissipate, said individual bypass diodes being accommodated juxtaposed with said one or more solar cell elements and electrically connected in parallel in relation to said one or more solar cell elements for allowing individual bypassing of each of said solar cell assemblies of said plurality of solar cell assemblies.
17. The solar module according to point 16, wherein said bypass diode assembly allows individual bypassing of each of said solar cell elements of said solar cell assembly.
18. The solar module according to any of the points 16-17, wherein said set of individual bypass diodes includes at least 2 individual bypass diodes, such as 2-5, 6-10 or 11-20, preferably 4-10, more preferably 6-8.
19. The solar module according to any of the points 16-18, wherein said bypass diodes are separated by 1-5 mm and preferably by 3 mm.
20. The solar module according to any of the any of the points 16-19, wherein said individual bypass diodes are being located at the periphery of said solar cell assembly.
21. The solar module according to any of the any of the points 16-20, wherein said individual bypass diodes define a thickness substantially equal to said thickness of said solar cell assembly.
22. The solar module according to point 21, wherein said thickness of said solar cell assembly is about 0.05-1 mm, preferably 0.2 mm.
23. The solar module according to any of the points 16-22, wherein said front and back plate of the enclosure may comprise any of the materials glass, polyester or EVA.
24. A solar module, comprising a shallow enclosure, comprising a back plate and a corresponding front plate, said front plate being transparent to solar light, said enclosure further comprising a solar cell assembly being accommodated between said front and back plates, said solar cell assembly comprising:
   a solar cell of semiconductor-based material exposed to solar light at said front plate,
   a piezoelectric alarm, being powered by said solar cell or solar cell assembly and/or said energy storage unit, said piezoelectric alarm being adapted for generating a sound pressure level of at least 100dB at a distance of 1 m from said solar module, and
   a control circuitry, being connected between said solar cell or solar cell assembly and said piezoelectric alarm for activating said piezoelectric alarm when said solar module has been removed from its installed location without any prior authorisation.
25. The solar module according to point 24, wherein said solar cell or solar cell assembly comprises an energy storage unit being connected to said solar cell or solar cell assembly for storing at least part of the electrical energy generated in said solar cell or solar cell assembly.
26. A solar module, comprising a shallow enclosure, comprising a back plate and a corresponding front plate, said front plate being transparent to solar light, said enclosure further comprising a solar cell assembly being accommodated between said front and back plates, said solar cell or solar cell assembly comprising:
   a solar cell of semiconductor-based material exposed to solar light at said front plate, and
   an energy storage unit for storing at least part of the electrical energy generated in said solar cell or solar cell assembly, said energy storage unit being electrically connected to said solar cell or solar cell assembly, and when said solar module is in use, said electrical storage unit selectively assuming either a storing mode, in which electrical energy is transported from said solar cell or solar cell assembly to said electrical storage unit when said solar cell or solar cell assembly is exposed to solar light or a delivering mode, in which electrical energy is transported from said storage unit to said solar cell or solar cell assembly for generating visual light.
27. The solar module according to point 26, wherein said electrical storage unit comprises a photo detection unit for determining whether said electrical storage unit should assume said storing mode or said delivering mode, said photo detection unit determining said storing mode to be assumed when the exposure to solar light exceeds a critical value, and said delivering mode when the exposure to solar light does not exceed said critical value.
28. The solar module according to any of the points 26-27, wherein said electrical storage unit comprises a control unit, and when in said delivering mode, said control unit selectively allows or prevents electrical energy being transported from said storage unit to said solar wafer for generating a specific light pattern.
29. A method of manufacturing a solar module by providing:
   a shallow enclosure, comprising a back plate and a corresponding front plate, said front plate being transparent for exposure to solar light,
   a plurality of solar cell assemblies, comprising one or more solar cell elements of semiconductor based material, and
   a plurality of bypass diode assemblies, said plurality of bypass diode assemblies being identical to said plurality of solar cell assemblies and each specific bypass diode assembly having a corresponding solar cell assembly, said plurality of bypass diode assemblies comprising a plurality of parallel- or series-connected individual bypass diodes being separated in relation to each other for allowing residual heat generated by said individual bypass diodes to dissipate,
      said method further comprising performing the following steps:
   encapsulating said solar cell assemblies within said enclosure between said front plate and said back plate and exposing said solar cell elements to solar light at said front plate, and
   accommodating said bypass diode assembly in a juxtaposed position in relation to said solar cell elements and electrically connecting said bypass diode assembly in parallel in relation to said one or more solar cell elements for allowing individual bypassing of each of said solar cell assemblies.
30. The method according to point 14, further comprising any of the features of points 16-29.

## Claims

1. A solar module (110), comprising a shallow enclosure, comprising a back plate (120) and a corresponding front plate (124), said front plate (124) being transparent to solar light, said enclosure further comprising a plurality of solar cell assemblies (10) and a plurality of bypass diode assemblies, all being accommodated between said front and back plates (124 120), said plurality of bypass diode assemblies being identical to said plurality of solar cell assemblies (10) and each specific bypass diode assembly having a corresponding solar cell assembly (10), each of said solar cell assemblies (10) comprising:
a string of series connected p-n junctions (112) exposed to solar light at said front plate (124), and
each of said bypass diode assemblies comprising:
a set of parallel- and/or series-connected individual bypass diodes (122), being separated in relation to each other for allowing residual heat generated by said individual bypass diodes (122) to dissipate, said individual bypass diodes (122) being accommodated juxtaposed with said string of series connected p-n junctions (112) and electrically connected in parallel in relation to said string of series connected p-n junctions (112) for allowing individual bypassing of each of said solar cell assemblies (10) of said plurality of solar cell assemblies (10).

2. The solar module (110) according to claim 1, wherein said bypass diode assembly allows individual bypassing of said string of series connected p-n junctions (112) of said solar cell assembly (10).

3. The solar module (110) according to any of the any of the claims 1-2, wherein said individual bypass diodes (122) are being located at the periphery of said solar cell assembly (10).

4. The solar module (110) according to any of the any of the claims 1-3, wherein said individual bypass diodes (122) define a thickness substantially equal to said thickness of said solar cell assembly (10).

5. A method of manufacturing a solar module (110) by providing:
a shallow enclosure, comprising a back plate (120) and a corresponding front plate (124), said front plate (124) being transparent for exposure to solar light,
a plurality of solar cell assemblies (10), comprising a string of series connected p-n junctions (112), and
a plurality of bypass diode assemblies, said plurality of bypass diode assemblies being identical to said plurality of solar cell assemblies (10) and each specific bypass diode assembly having a corresponding solar cell assembly (10), said plurality of bypass diode assemblies comprising a plurality of parallel- or series-connected individual bypass diodes (122) being separated in relation to each other for allowing residual heat generated by said individual bypass diodes (122) to dissipate,
said method further comprising performing the following steps:
encapsulating said solar cell assemblies (10) within said enclosure between said front plate (124) and said back plate (120) and exposing said strings of series connected p-n junctions (112) to solar light at said front plate (124), and
accommodating said bypass diode assembly in a juxtaposed position in relation to said string of series connected p-n junctions (112) and electrically connecting said bypass diode assembly in parallel in relation to said string of series connected p-n junctions (112) for allowing individual bypassing of each of said solar cell assemblies (10).

## Patentansprüche

1. Solarmodul (110) umfassend ein flaches Gehäuse umfassend eine Hinterplatte (120) und eine entsprechende Vorderplatte (124), wobei die Vorderplatte (124) für Sonnenlicht durchlässig ist, wobei das Gehäuse ferner eine Mehrzahl von Solarzellenanordnungen (10) und eine Mehrzahl von Bypassdiodenanordnungen umfasst, die alle zwischen der Vorder- und Hinterplatte (124 120) untergebracht sind, wobei die Mehrzahl von Bypassdiodenanordnungen mit der Mehrzahl von Solarzellenanordnungen (10) identisch ist, und jede spezifische Bypassdiodenanordnung eine entsprechende Solarzellenanordnung (10) aufweist, wobei jede der Solarzellenanordnungen (10) umfasst:
eine Kette von in Reihe geschalteten p-n Übergängen (112), die an der Vorderplatte (124) Sonnenlicht ausgesetzt sind, und
wobei jede der Bypassdiodenanordnungen umfasst:
einen Satz parallel- und/oder in Reihe geschaltete individuelle Bypassdioden (122), die in Bezug aufeinander getrennt sind, um Abführung der durch die individuellen Bypassdioden (122) erzeugten Restwärme zu erlauben, wobei die individuellen Bypassdioden (122) neben der Kette von in Reihe geschalteten p-n Übergängen (112) untergebracht und in Bezug auf die Kette von in Reihe geschalteten p-n Übergängen (112) elektrisch parallelgeschaltet sind, um individuelle Umleitung jeder der Solarzellenanordnungen (10) der Mehrzahl von Solarzellenanordnungen (10) zu erlauben.

2. Solarmodul (110) nach Anspruch 1, wobei die Bypassdiodenanordnung individuelle Umleitung der Kette von in Reihe geschalteten p-n Übergängen (112) der Solarzellenanordnung (10) erlaubt.

3. Solarmodul (110) nach einem der Ansprüche 1-2, wobei die individuellen Bypassdioden (122) an der Peripherie der Solarzellenanordnung (10) angeordnet sind.

4. Solarmodul (110) nach einem der Ansprüche 1-3, wobei die individuellen Bypassdioden (122) eine Dicke im Wesentlichen gleich der Dicke der Solarzellenanordnung (10) definieren.

5. Verfahren zur Herstellung eines Solarmoduls (110) durch Bereitstellen:
eines flachen Gehäuses umfassend eine Hinterplatte (120) und eine entsprechende Vorderplatte (124), wobei die Vorderplatte (124) für Sonnenlicht durchlässig ist.
einer Mehrzahl von Solarzellenanordnungen (10) umfassend eine Kette von in Reihe geschalteten p-n Übergängen (112), und
einer Mehrzahl von Bypassdiodenanordnungen, wobei die Mehrzahl von Bypassdiodenanordnungen mit der Mehrzahl von Solarzellenanordnungen (10) identisch ist, und jede spezifische Bypassdiodenanordnung eine entsprechende Solarzellenanordnung (10) aufweist, wobei die Mehrzahl von Bypassdiodenanordnungen eine Mehrzahl von parallel- und in Reihe geschalteten individuellen Bypassdioden (122) umfasst, die in Bezug aufeinander getrennt sind, um Abführung der durch die individuellen Bypassdioden (122) erzeugten Restwärme zu erlauben,
wobei das Verfahren ferner die folgenden Schritte umfasst:
Einkapseln der Solarzellenanordnungen (10) innerhalb des Gehäuses zwischen der Vorderplatte (124) und der Hinterplatte (120) und Aussetzen der Ketten von in Reihe geschalteten p-n Übergängen (112) Sonnenlicht an der Vorderplatte (124), und
Unterbringen der Bypassdiodenanordnung in einer nebeneinanderliegenden Position in Bezug auf die Kette von in Reihe geschalteten p-n Übergängen (112) und elektrisches Parallelschalten der Bypassdiodenanordnung in Bezug auf die Kette von in Reihe geschalteten p-n Übergängen (112), um individuelle Umleitung jeder der Solarzellenanordnungen (10) zu erlauben.

## Revendications

1. Module solaire (110) comprenant un logement peu profond, comprenant une plaque arrière (120) et une plaque avant (124), ladite plaque avant (124) étant transparente à ladite lumière solaire, ledit logement comprenant en outre une pluralité d'assemblages de cellules solaires (10) et une pluralité d'assemblages de diodes de dérivation, toutes étant accommodées entre lesdites plaques avants et arrières (124, 120), ladite pluralité d'assemblages de diodes de dérivation étant identique à ladite pluralité d'assemblages de cellules solaires (10) et chaque assemblage de diode de dérivation ayant un assemblage de cellule solaire (10) correspondant, dont chaque assemblage de cellule solaire (10) comprend:
une chaîne de jonctions p-n connectées en série (112) exposée à la lumière solaire à ladite plaque avant (124), et
chacun desdites assemblages de diodes de dérivation comprenant:
un ensemble de diodes de dérivation individuelles connectées en parallèle ou en série (122), étant séparées les unes par rapport aux autres pour permettre à la chaleur résiduelle générée par lesdites diodes de dérivation individuelles (122) de dissiper, lesdites diodes de dérivation individuelles (122) étant accommodées juxtaposées avec ladite chaîne de jonctions p-n connectées en série (112) et connectées électriquement en parallèle par rapport à ladite chaîne de jonctions p-n connectées en série (112) pour permettre la dérivation individuelle de chacun desdits assemblages de cellules solaires (10) de ladite pluralité d'assemblages de cellules solaires (10).

2. Module solaire (110) selon la revendication 1, dans lequel ledit assemblage de diode de dérivation permet la dérivation individuelle de ladite chaîne de jonctions p-n connectées en séries (112) dudit assemblage de cellule solaire (10).

3. Module solaire (110) selon l'une quelconque des revendications 1 à 2, dans lequel lesdites diodes de dérivation individuelles (122) sont localisées à la périphérie dudit assemblage de cellule solaire (10).

4. Module solaire (110) selon l'une quelconque des revendications 1 à 3, dans lequel lesdites diodes de dérivation individuelles (122) définissent une épaisseur substantiellement égale à ladite épaisseur dudit assemblage de cellule solaire (10).

5. Procédé de fabrication d'un module solaire (110) en fournissant:
un logement peu profond, comprenant une plaque arrière (120) et une plaque avant (124), ladite plaque avant (124) étant transparente à ladite lumière solaire,
une pluralité d'assemblages de cellules solaires (10) comprenant une chaîne de jonctions p-n connectées en série (112), et
une pluralité d'assemblages de diodes de dérivation, ladite pluralité d'assemblages de diodes de dérivation étant identique à ladite pluralité d'assemblages de cellules solaires (10) et chaque assemblage de diode de dérivation spécifique ayant un assemblage de cellule solaire correspondant (10), ladite pluralité d'assemblages de diodes de dérivation comprenant une pluralité de diodes de dérivation individuelles connectées en série ou en parallèle (122) étant séparées les unes par rapport aux autres pour permettre à la chaleur résiduelle générée par lesdites diodes de dérivation individuelles (122) de dissiper,
ledit procédé comprenant en outre les étapes suivantes:
l'encapsulation desdits assemblages de cellule solaire (10) à l'intérieur dudit logement entre ladite plaque avant (124) et ladite plaque arrière (120) et l'exposition desdites chaînes de jonctions p-n connectées en série (112) à la lumière solaire à ladite plaque avant (124), et
l'accommodation dudit assemblage de diode de dérivation dans une position juxtaposée par rapport à ladite chaîne de jonctions p-n connectées en série (112) et la connexion électrique dudit assemblage de diode de dérivation en parallèle par rapport à ladite chaîne de jonctions p-n connectées en série (112) pour permettre la dérivation individuelle de chacun desdits assemblages de cellule solaire (10).
